# EUROPÄISCHE PATENTSCHRIFT

(11) **EP 0 633 503 B1**
(45) Veröffentlichungstag und Bekanntmachung des Hinweises auf die Patenterteilung: **09.07.1997**
(21) Anmeldenummer: 94810379.1
(22) Anmeldetag: 24.06.1994
(51) Int. Cl.: G03F 7/032, G03F 7/038

(54) **Photopolymerisierbare Zusammensetzungen**
Photopolymerizable compositions
Compositions photopolymérisables

(30) Priorität: 02.07.1993 CH 2005/93
(43) Veröffentlichungstag der Anmeldung: 11.01.1995
(73) Patentinhaber: Ciba Specialty Chemicals Holding Inc., 4057 Basel (CH)
(72) Erfinder: Salvin, Roger Pierre-Elie, Dr., D-79576 Weil am Rhein (DE); Roth, Martin, Dr., CH-1735 Giffers (CH)

(56) Entgegenhaltungen:
- EP-A- 0 302 827
- GB-A- 1 187 652
- DATABASE WPI Section Ch, Week 9248, Derwent Publications Ltd., London, GB; Class A89, AN 92-394823 & JP-A-4 294 352 (TAMURA KAKEN CO LTD) 19. Oktober 1992

## Beschreibung

Die Erfindung betrifft neue wässrige photopolymerisierbare Zusammensetzungen, ein Verfahren zu deren Herstellung, und die Verwendung der neuen Zusammensetzungen vor allem zur Beschichtung von Leiterplatten.

Photopolymerisierbare Zusammensetzungen für die Verwendung als Photoresists, z.B. zur Beschichtung von Leiterplatten und zur Herstellung von Lötstoppmasken, sind seit langem bekannt.

So beschreibt z.B. die EP 493317 strahlungsempfindliche Zusammensetzungen, die Polymere als Bindemittel mit vorteilhaft einem Erweichungspunkt über 80°C sowie photopolymerisierbare Acrylat- und/oder Methacrylatmonomere und Photoinitiatorverbindungen enthalten und wässrig appliziert werden können.

Die US Patentschrift 5,045,435 beschreibt weiter Photoresistbeschichtungs-Zusammensetzungen enthaltend ein Acrylatmonomer, einen Photoinitiator und als Bindemittel ein Latex eines wasserunlöslichen carboxylierten (Meth)acrylates Copolymers; diese Zusammensetzungen sind ebenfalls wässrig applizierbar.

Derartige Zusammensetzungen enthalten demnach hochmolekulare Binderpolymere und relativ niedermolekulare Acrylate und sind wässrig applizierbar.

Photochemisch oder thermisch gehärtete Epoxyacrylate, die sich von niedermolekularen Epoxyharzen und Epoxynovolaken ableiten, sind zwar für ihre guten thermischen und mechanischen Eigenschaften sowie ihre gute chemische Beständigkeit gegen agressive Chemikalien bekannt. Allerdings lassen die Klebrigkeit und die Kantendeckung der mit diesen Systemen erhaltenen Resistfilme auf Leiterzügen wegen der relativ niedrigen Molmasse zu wünschen übrig. Man ist deshalb in der Anwendung vielfach gezwungen, diese Nachteile durch den Zusatz von hochmolekularen Binderpolymeren zu umgehen. Diese weisen normalerweise keine funktionellen Acrylatgruppen auf und reagieren bei der photochemischen oder thermischen Härtung nicht mit, d.h. sie werden als "passive" Bestandteile im Netzwerk nicht eingebaut und führen somit zu einer Verdünnung der Netzwerkdichte. Dies hat wieder eine ungünstige Beeinflussung speziell der chemischen Beständigkeit und der elektrischen Eigenschaften von prozessierten Resistschichten zur Folge. Ausserdem sinkt die Photoempfindlichkeit infolge der "Verdünnung" der Acrylatgruppen. Durch die Verwendung von hochmolekularen Binderpolymeren weisen diese Zusammensetzungen bereits bei relativ niedrigem Festkörpergehalt eine hohe Viskosität auf und führen daher oft zu grossen Problemen bei der Beschichtung.
Schliesslich werden in der japanischen Patentanmeldung Veröffentlichungsnummer Hei 04-294352 wasserdispergierbare Harzflüssigkeiten vorgeschlagen, welche durch Reaktion eines aromatischen Epoxyharzes mit einer ungesättigten Monocarbonsäure, dann mit einem Anhydrid einer ungesättigten Polycarbonsäure und anschliessend durch Neutralisation mit einem Amin hergestellt werden und als photoempfindliche Zusammensetzungen eingesetzt werden können.

Aufgabe der Erfindung war es daher, photopolymerisierbare Zusammensetzungen zu entwickeln, welche die aufgezeigten nachteiligen Effekte nicht haben und vor allem ohne den Zusatz von hochmolekularen Binderpolymeren auskommen, ferner eine geringere Klebrigkeit und eine sehr gute Kantendeckung aufweisen und wässrig applizierbar sind.

Die Lösung dieses Problems findet sich in einer neuen photopolymerisierbaren Zusammensetzung, die ohne Zusatz von hochmolekularen Binderpolymeren auskommen, enthaltend
a) 20 bis 80 Gew.% eines spezifischen, filmbildenden, Säuregruppen enthaltenden Acrylates mit höherem Molekulargewicht, welches mit Ammoniak oder einem Amin oder einer anorganischen Base neutralisiert ist, wobei mindestens 10 Gew.% der Komponente a) aus einem höhermolekularem Acrylat al) bestehen, welches sich aus einem Reaktionsprodukt eines höhermolekularen, mit einem Bisphenol avancierten Epoxyharzes und einer ethylenisch ungesättigten Monocarbonsäure und nach anschliessender Umsetzung mit einem cyclischen Anhydrid einer organischen Polycarbonsäure herleitet,
b) 0,1 bis 15 Gew.% einer Photoinitiatorverbindung,
c) gegebenenfalls 1 bis 25 Gew.% Zusätze, und
d) Wasser oder neben Wasser noch bis zu 15 Gew.% eines organischen Lösungsmittels enthält, und Wasser die Balance zu 100 Gew.% bildet, sowie
e) gegebenenfalls noch mindestens ein (Meth)Acrylat-Monomer oder (Meth)Acrylat-Oligomer oder eine durch Licht vernetzbare Vinylverbindung enthält.

Bevorzugte Zusammensetzungen enthalten als Komponente a) von 20 bis 100, insbesondere von 40 bis 100 Gew.% eines höhermolekularen Acrylharzes a1).

Ganz bevorzugt sind solche Zusammensetzungen, welche die genannten Komponenten in folgenden Mengenverhältnissen enthalten: 20 bis 60 Gew.% der Komponente a), 1 bis 10 Gew.% der Komponente b), 1 bis 15 Gew.% der Komponente c), und die Komponente d) als Ergänzung auf 100 %.

Als Acrylate für die Komponente a) kommen alle bekannten, filmbildenden, Säuregruppen enthaltenden, polyfunktionellen und mit Ammoniak oder einem Amin neutralisierbaren Acrylate in Betracht; Weiter kommen als Neutralisationsmittel auch anorganische Basen in Betracht, wie z.B. Natrium- oder Kaliumhydroxid.

Geeignet sind z.B. Reaktionsprodukte von Epoxyverbindungen, wie Epoxynovolaken oder Bisphenol-A-Epoxyharzen, mit (Meth)Acrylsäure und mehrbasischen cyclischen Carbonsäureanhydriden, sowie Umsetzungsprodukte von Polycarbonsäuren mit glycidylgruppen- oder epoxygruppenhaltigen Acrylaten oder mit Hydroxylgruppen enthaltenden Acrylaten.

Viele dieser Acrylate sind bekannt und sind teilweise auch kommerziell erhältlich. Ihr mittleres Molekulargewicht liegt bei Werten von etwa 1'000 bis 500'000, bevorzugt aber über 2'000.

Besonders bevorzugt sind aber solche Acrylate al), die ein mit einem cyclischen Anhydrid einer Polycarbonsäure umgesetztes acryliertes Derivat von mit Bisphenolen avancierten Epoxyharzen enthalten und in den am 2. Juli 1993 hinterlegten Schweizerischen Patentanmeldungen (Anmeldenummern 2003/93-0 und 2004/93-2, Titel: Epoxyacrylate) beschrieben sind. Gemäss der Schweizerpatentanmeldung Anmeldenummer 2004/93-2 besonders bevorzugt sind die Epoxyacrylate der Formeln II und III: 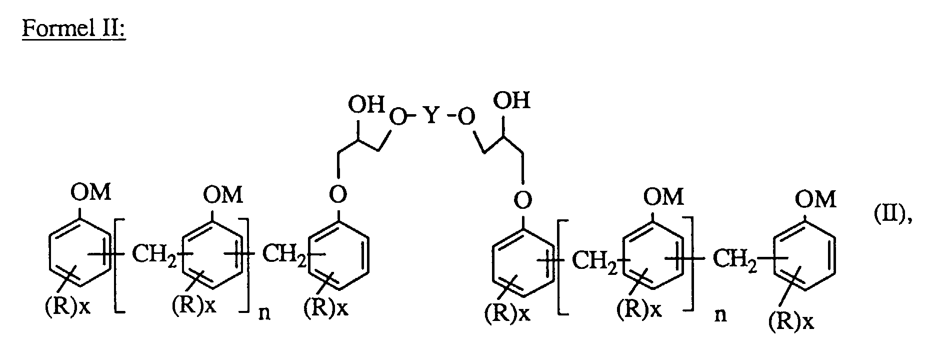 worin
- M: die Gruppe der Formeln 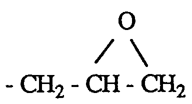 oder 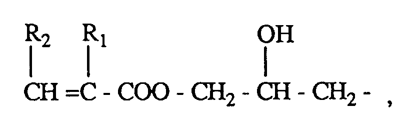
- R₁: -H oder -CH₃, R₂ -H, -CH₃ oder Phenyl,
- R: C₁-C₄ Alkyl oder Halogen, vorzugsweise CH₃ oder Br,
- x: eine ganze Zahl von 0 bis 3, vorzugsweise 0 oder 1, und
- Y: ein Brückenglied der Formeln 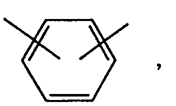 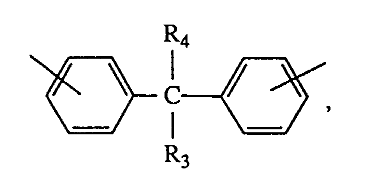 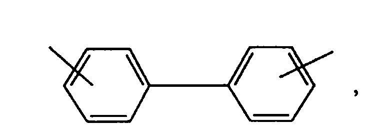 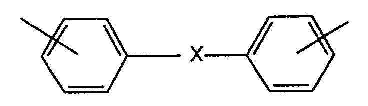 oder 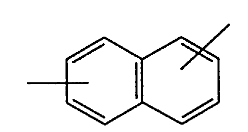 bedeuten,
wobei R₃ und R₄ unabhängig voneinander Wasserstoff oder C₁-C₄-Alkyl bedeuten oder R₃ und R₄ zusammen mit dem C-Atom, an dem sie gebunden sind, einen 5- oder 6-gliedrigen Kohlenwasserstoff-Ring bilden, und die aromatischen Reste des Brückengliedes Y unsubstituiert oder durch Halogen oder C₁-C₄ Alkyl substituiert sind,
X -S-, -O-, oder -SO₂-, und
n eine ganze Zahl von 0 bis 300, bedeuten,
wobei mindestens 10 Mol % der Reste M die Struktur der Formel 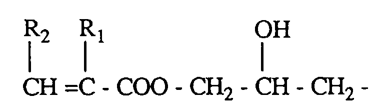 aufweisen, wobei R₁ und R₂ die oben angegebene Bedeutung haben;
   Ganz besonders bevorzugte Epoxyacrylate haben die Formel II, worin R -H oder -CH₃, R₁ -H oder -CH₃, R₂ -H, x die Zahl 0 oder 1, n eine ganze Zahl von 0 bis 30 und Y ein Brückenglied der Formel 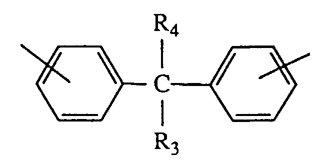 sind, worin
   R₃ und R₄ -H oder C₁-C₄ Alkyl und die aromatischen Reste des Brückengliedes unsubstituiert oder durch Halogen oder C₁-C₄ Alkyl substituiert sind, vor allem aber worin Y ein Brückenglied der Formel 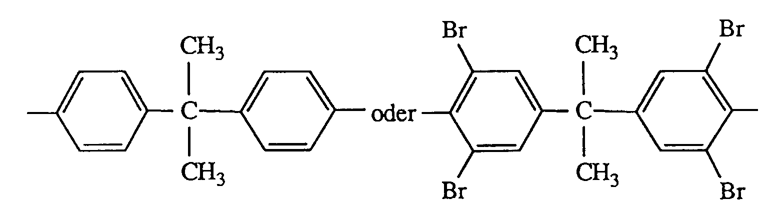 darstellt, und
   R₁ -H oder -CH₃ und R₂ -H sind, 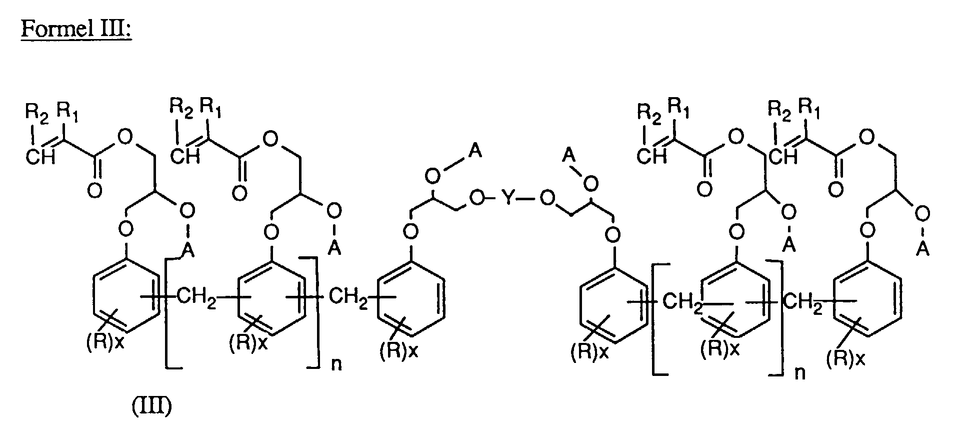 worin
   - A: Wasserstoff oder die Gruppe der Formel 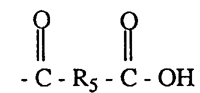 bedeutet, und
   R₁, R₂, R, n, x und Y die oben für Formel II angegebene Bedeutung haben und R₅ den Rest eines cyclischen Anhydrides einer Polycarbonsäure nach Entfernen des Anhydridrestes darstellt, und wobei mindestens 10 Mol % der Reste A die Struktur der obigen Formel 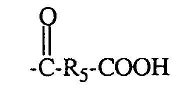 aufweisen.

Bevorzugte Epoxyacrylate der Formel III entsprechen den bevorzugten Epoxyacrylate der oben angegebenen Formel II, wobei die Reste R₁, R₂, R, x, n und Y in der Formel III die gleichen, für Formel II bevorzugten Bedeutungen haben.

Gemäss der Schweizerpatentanmeldung Anmeldenummer 2003/93-0 besonders bevorzugt sind die Epoxyacrylate der Formeln IIIa) und IV: 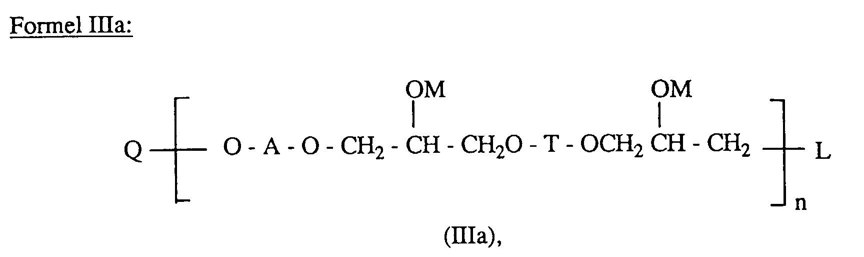 worin
- Q: Wasserstoff oder eine Gruppe der Formeln 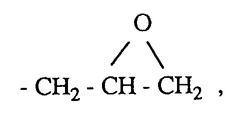 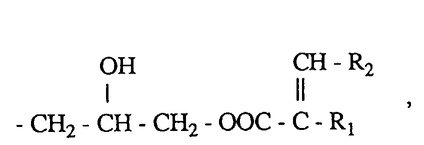 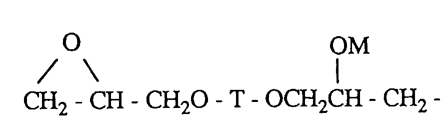 oder 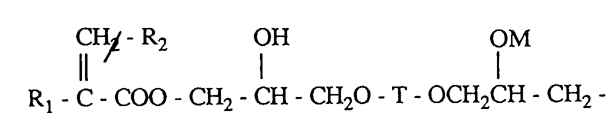 bedeutet,
- R₁: -H oder -CH₃,
- R₂: -H, -CH₃ oder Phenyl,
- T: den Rest einer bifunktionellen aromatischen Verbindung,
- M: Wasserstoff oder eine Gruppe der Formel 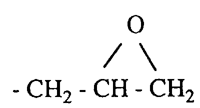 oder 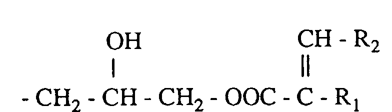 bedeuten, wobei
- R₁ und R₂: die oben angegebene Bedeutung haben,
- A: den Rest einer bifunktionellen aromatischen Verbindung,
- n: eine ganze Zahl von 0 bis 300, und
- L: eine Gruppe der Formeln 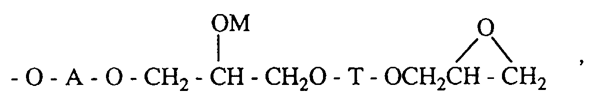 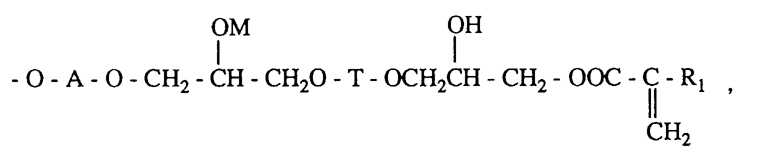 oder - O - A - OM bedeuten,
wobei in der Formel IIIa) nicht alle Reste M gleichzeitig Wasserstoff oder eine Gruppe der Formel 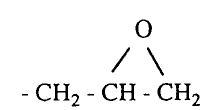 bedeuten können, sondern mindestens 10 Mol %, vorzugsweise 20-100 Mol % der Reste M, die nicht in den Endgruppen Q und L sind, eine Gruppe der obigen Formel 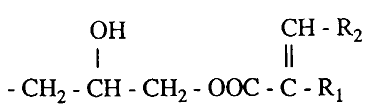 darstellen,
wobei R₁ und R₂ die oben angegebene Bedeutung haben,
ganz bevorzugt aber der Formel IIIa), worin R₁ Wasserstoff oder Methyl und R₂ Wasserstoff, Methyl oder Phenyl bedeuten, und worin n eine ganze Zahl von 0 bis 50 und A und T unabhängig voneinander ein Brückenglied der Formel 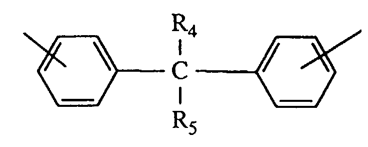 bedeuten,
wobei R₄ und R₅ unabhängig voneinander -H oder C₁-C₄-Alkyl sind und die Phenylreste des Brückengliedes unsubstituiert oder durch Brom substituiert sind,

### Carboxylgruppenhaltige Epoxyacrylate der Formel IV:

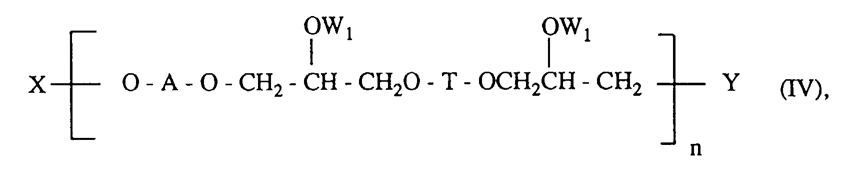

worin
- X: Wasserstoff oder eine Gruppe der Formeln 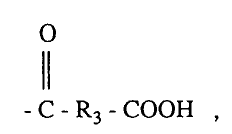 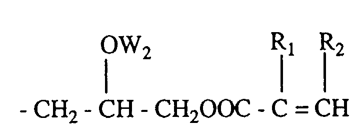 oder 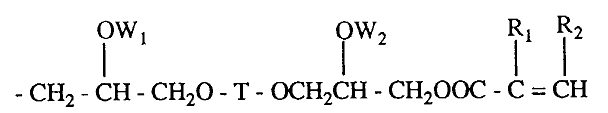 bedeutet,
- R₃: den Rest eines cyclischen Anhydrides einer Polycarbonsäure nach Entfernung des Anhydridrestes,
- W₁: Wasserstoff oder eine Gruppe der Formeln 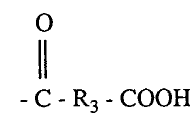 oder 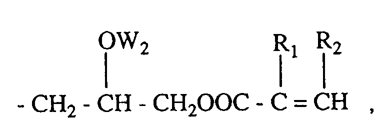
- W₂: -H oder die Gruppe 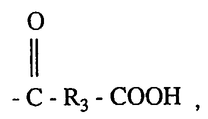 und
- Y: die Gruppe der Formeln -O-A-O-W₁ oder 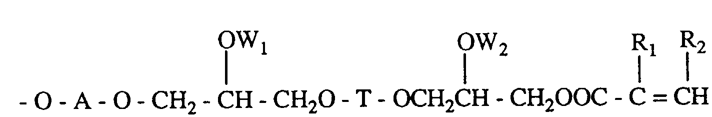 bedeuten, und
worin die Symbole A, T, R₁, R₂ und n die oben für Formel IIIa) angegebene Bedeutung haben, wobei in der Formel IV mindestens 10 Mol % der Reste W₁, die nicht in den Endgruppen X und Y sind, eine Gruppe der Formel 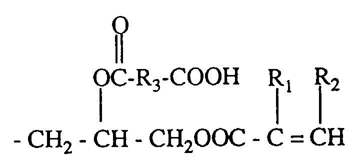 darstellen,
wobei R₁, R₂ und R₃ die oben angegebene Bedeutung haben.

Die Säurezahl der Acrylat-Komponente a) [mg benötigtes KOH zur Neutralisation von 1 g Acrylat], die die Zahl freier Carboxylgruppen charakterisiert, sollte vor der Umsetzung mit Ammoniak bzw. den Aminen mindestens 25 betragen, um gute Eigenschaften der Zusammensetzung im Hinblick auf Wasserlöslichkeit und auf Entwickelbarkeit in wässerig-alkalischen Lösungen zu gewährleisten. Noch besser und daher bevorzugt sind Säurezahlen über 60.

Die Umsetzung der Carboxylgruppen mit Ammoniak oder den Aminen führt im Sinne einer Neutralisationsreaktion zu den entsprechenden Ammonium- oder Amincarboxylaten. Diese relativ ionischen Carboxylatgruppen bewirken, dass die Acrylate sich gut in Wasser lösen oder dispergieren lassen. Bei einer thermischen Behandlung einer solchen Zusammensetzung, wie beispielsweise bei der Trocknung einer Beschichtung aus der Zusammensetzung oder bei der thermischen Härtung einer solchen Beschichtung, können sich hingegen die Ammoniumcarboxylatgruppen wieder zersetzen, und die Basen verflüchtigen.

Für die Umsetzung der Carboxylgruppen an den genannten Acrylaten sind eine grosse Zahl von Aminen geeignet. In Frage kommen alle Arten von Aminen, wie primäre, sekundäre und tertiäre Amine, ebenso wie Heterocyclen mit Stickstoff. Ihre Auswahl wird lediglich dadurch eingeschränkt, dass die mit den Aminen umgesetzte Carboxylgruppen enthaltenden Acrylate wasserlöslich sein sollen. Daher sollten die an den Aminstickstoff gebundenen organischen Reste bevorzugt nur relativ wenige Kohlenstoffatome enthalten. Bevorzugt weisen die organischen Reste der Amine Substituenten auf, die die Löslichkeit in Wasser fördern, z.B. Hydroxylgruppen. Geeignete Amine sind beispielsweise niedrige Alkylamine, wie Monomethyl-, Dimethyl- und Trimethylamin, entsprechende reine Ethyl-, Propyl- und Butylamine, ebenso wie die genannten Reste enthaltende gemischte Amine. Gut geeignete Amintypen sind auch Alkanolamine, wie Ethanolamin, Dimethylethanolamin, Diethanolamin, Triethanolamin oder 2-Amino-2-methyl-1,3-propandiol. Auch aromatische Amine, z.B. Anilin, können in Frage kommen. Als Beispiel für einen Aminstickstoff enthaltenden Heterocyclus sei Morpholin genannt. Bevorzugt ist Ammoniak.

Geeignete Amine kann man weiterhin aufgrund ihrer Flüchtigkeit und ihres Siedepunktes in zwei Gruppen einteilen. Die erste Gruppe umfasst die Amine, die im Vergleich zu Wasser relativ flüchtig sind, z.B. solche, die bei gleicher Temperatur eine niedrigere Verdunstungszahl bzw. einen höheren Dampfdruck als Wasser aufweisen. Im allgemeinen wird es sich hierbei um Amine mit Siedepunkten unterhalb etwa 80°C handeln. Die zweite Gruppe umfasst die Amine, die weniger flüchtig sind als Wasser mit Siedepunkten im allgemeinen über 100°C. Beispiele sind Dimethylethanolamin, Diethanolamin, Triethanolamin oder 2-Amino-2-methyl-1,3-propandiol.

Bei den Zusammensetzungen, basierend auf den Aminen der ersten Gruppe, kann die Trocknung der applizierten Zusammensetzung bzw. die Bildung eines Films aus der Zusammensetzung bei Temperaturen von etwa 70°-100°C erfolgen, bei denen sich die entstandenen Ammoniumcarboxylatgruppen des Acrylats bereits wieder zersetzen und sich das freie Amin bereits im wesentlichen aus der trocknenden Zusammensetzung verflüchtigt. Aufgrund der rückgebildeten freien Carboxylgruppen am Acrylat sind diese Zusammensetzungen in wässrigem Alkali löslich. Spezielle erfindungsgemässe Zusammensetzungen sind demnach diejenigen, bei denen die Carboxylgruppen mit Aminen umgesetzt sind, die so gewählt sind, dass sie sich zumindest bei der Temperatur schon wieder verflüchtigen, die für die Bildung eines Films der strahlungsempfindlichen Zusammensetzung aus der Photopolymerlösung angewendet wird.

Die Ammoniumcarboxylatgruppen (am filmbildenden Acrylat) der erfindungsgemässen Zusammensetzungen, die auf weniger flüchtige Amine basieren, zersetzen sich hingegen auch bei den Temperaturen, wie sie zur Trocknung der Zusammensetzungen vorteilhaft sind, höchstens in geringem Masse. Auf Grund der in solchen Filmen daher noch vorhandenen grossen Zahl ionischer bzw. stark polarer Ammoniumcarboxylatreste sind diese Filme in Wasser löslich.

Selbstverständlich ist es aber auch möglich, wasserlösliche Filme aus Zusammensetzungen, basierend auf Ammoniak oder den relativ flüchtigen Aminen der ersten Gruppe, zu erhalten, wenn entsprechend schonende Trocknungsverfahren eingesetzt werden, bei denen sich Ammoniumcarboxylatreste nicht zersetzen können.

Als Photoinitatoren der Komponente b) können alle bekannten Typen verwendet werden, die photosensitiv und radikalbildend sind und welche in die photopolymerisierbare Zusammensetzung einemulgierbar sind.

Gewünschtenfalls können zusätzlich Coinitiatoren und/oder Sensibilisatoren eingesetzt werden.

Geeignete Beispiele für Photoinitiatoren sind aromatische Carbonylverbindungen, wie beispielsweise Benzoin, Benzoinalkylether, wie der Isopropyl- oder der n-Butylether, α-substituierte Acetophenone, insbesondere Benzilketale, wie Benzildimethylketal, oder α-halogensubstituierte Acetophenone, wie Trichlormethyl-p-tert.butylphenyl-keton oder Morpholino-methyl-phenyl-keton, oder Dialkoxyacetophenone, wie Diethoxyacetophenon, oder α-Hydroxyacetophenone, wie 1-Hydroxycyclohexyl-phenyl-keton; oder Benzophenone, wie Benzophenon oder Bis-(4-dimethylamino)-benzophenon; oder Metalloceninitiatoren, wie Titanoceninitiatoren, z.B. Bis-(π-methylcyclopentadienyl)-bis-(σ-pentafluorophenyl)-titan-IV; oder ein Stannan in Kombination mit einem photoreduzierbaren Farbstoff, beispielsweise Trimethyl-benzyl-stannan in Kombination mit Methylenblau oder Bengalrosa; oder ein Chinon oder ein Thioxanthon in Kombination mit einem Amin, das an einem α-C-Atom mindestens ein Wasserstoffatom aufweist, wie Anthrachinon, Benzochinon oder Thioxanthon in Kombination mit Bis-(4-dimethylamino)-benzophenon oder Triethanolamin; oder ein Thioxanthon, beispielsweise ein Alkyl- oder Halogen-substituiertes Thioxanton, wie 2-Isopropylthioxanthon oder 2-Chlorthioxanthon; oder Acylphosphinoxide oder Bisacylphosphinoxide.

Vorteilhaft kommen z.B. als oben erwähnte Photoinitiatoren Irgacure 907® und Quantacure ITX®, ferner Irgacure 369®, Irgacure 651® und Luzirin TPO® in Betracht. Irgacure 907® und Quantacure ITX® sind bevorzugt.

Die erfindungsgemässen Zusammensetzungen können als weitere Zusätze c) z.B. folgende Komponenten enthalten:
Thermische Härter in Mengen von etwa 1 bis 20 Gew.%, wie N-Methylolacrylamid, Epoxydharze, blockierte Isocyanate und Melaminharze;
Pigmente oder wasserunlösliche Farbstoffe in Mengen von etwa 0,1 bis 2 Gew.%, wie Mikrolith Blau 4G, Orasolblau GN und Irgalithgrün GLN.
Füllstoffe wasserverträglicher, organischer und anorganischer Natur in Mengen von etwa 5 bis 15 Gew.%, wie Talk, Quarz (SiO₂), Bariumsulfat (BaSO₄), Aluminiumoxyd und Calciumcarbonate, mit denen z.B. die Eigenschaften einer Beschichtung, wie deren Hitzebeständigkeit, die Haftung oder die Kratzfähigkeit, verbessert werden können;
Zusätze für wässrige Lacke (Lackadditive) in einer Gesamtmenge von etwa 0,1 bis 5 Gew.%, wie Entschäumer (z.B. Byk 80), Haftvermittler (z.B. Benzotriazol), Fungizide, Thixotropiemittel und zusätzlich bis zu 15 % eines organischen Lösungsmittels, wie Methoxypropanol, Methoxypropylacetat und Butylglykol.

Die erfindungsgemässen Zusammensetzungen enthalten als Komponente d) Wasser als im wesentlichen einziges Lösungs- und/oder Emulsionsmittel. Allerdings enthalten die Zusammensetzungen gemäss der Komponente d) neben Wasser noch bis zu 15 Gew.% eines organischen Lösungsmittels, wenn z.B. die für die Zusammensetzungen verwendeten Komponenten in solchen Lösungsmittel gelöst/emulgiert sind. Wasser bildet dann die Balance zu 100 Gew.%.

Der Wassergehalt der Zusammensetzungen wird dabei weitgehend von dem gewünschten Festkörpergehalt für die Zusammensetzung bestimmt sein. Bevorzugt sind Zusammensetzungen, die etwa 40 bis 80 Gew.% Wasser enthalten, und im Normalfall Emulsionen oder Dispersionen sind.

Gegebenenfalls enthalten die photopolymerisierbaren Zusammensetzungen als Komponente e) mindestens ein (Meth)Acrylat-monomer oder -oligomer zweckmässig in einer Menge zwischen 5 und 50 Gew.%, bezogen auf die Komponenten a). Als derartige Verbindungen kommen z.B. in Frage:
1) Mono(meth)acrylate,
2) Di(meth)acrylate,
3) Poly(meth)acrylate mit einer Funktionalität von mindestens 3.

In den erfindungsgemässen Zusammensetzungen können als Komponente 1) beispielsweise folgende Verbindungen enthalten sein: Allylacrylat, Allylmethacrylat, Methyl-, Ethyl-, n-Propyl-, n-Butyl-, Isobutyl-, n-Hexyl-, 2-Ethylhexyl-, n-Octyl-, n-Decyl- und n-Dodecyl-acrylat und -methacrylat, 2-Hydroxyethyl-, 2- und 3-Hydroxypropyl-acrylat und -methacrylat, 2-Methoxyethyl-, 2-Ethoxyethyl- und 2- oder 3-Ethoxypropyl-acrylat, Tetrahydrofurfurylmethacrylat, 2-(2-Ethoxyethoxy)ethylacrylat, Cyclohexylmethacrylat, 2-Phenoxyethylacrylat, Glycidylacrylat und Isodecylacrylat. Solche Produkte sind ebenfalls bekannt und zum Teil im Handel erhältlich, zum Beispiel von der Firma SARTOMER Company.

Als Komponente 2) eignen sich beispielsweise die Diacrylat- und Dimethacrylatester von aliphatischen oder cycloaliphatischen Diolen, wie 1,3-Butylenglykol, 1,4-Butandiol, Neopentylglykol, 1,6-Hexandiol, Diethylenglykol, Triethylenglykol, Tetraethylenglykol, Polyethylenglykol-400, Polyethylenglykol-600, Tripropylenglykol, ethoxyliertes oder propoxyliertes Neopentylglykol, 1,4-Dihydroxymethylcyclohexan, 2,2-Bis-(4-hydroxycyclohexyl)-propan oder Bis-(4-hydroxycyclohexyl)-methan, sowie die üblichen, zu diesem Zweck verwendbaren Urethanacrylate, Polyesteracrylate oder Epoxyacrylate.

Als Komponente 3) können beispielsweise folgende Verbindungen eingesetzt werden: 1,1,1-Trimethylolpropantri-acrylat oder -methacrylat, ethoxyliertes 1,1,1-Trimethylolpropantri-acrylat oder -methacrylat, Pentaerythritoltetraacrylat, Pentaerythritolmonohydroxytri-acrylat oder -methacrylat, Dipentaerythritolmonohydroxypenta-acrylat oder -methacrylat. Solche Verbindungen sind bekannt und zum Teil im Handel erhältlich, beispielsweise von der Firma SARTOMER Company unter der Produktebezeichnung SR-295, SR-350, SR-351, SR-367, SR-399, SR-444 und SR-454, sowie die üblichen, zu diesem Zweck verwendeten Urethanacrylate, Polyesteracrylate oder Epoxyacrylate.

Als durch Licht vernetzbare Vinylverbindungen kommen z.B. N-Vinylpyrrolidon oder N-Vinylcaprolactam in Frage.

Die erfindungsgemässen Zusammensetzungen stellen infolge des Fehlens von zusätzlichen hochmolekularen Binderpolymeren wässrige Photolacke dar, die nach der Trocknung nicht klebrig sind, gute elektrische Werte im feuchten Klima (relative Luftfeuchtigkeit >80 %) und eine hohe Photoempfindlichkeit aufweisen und keine elektrolytische Korrosion unter Spannung im feuchten Klima ergeben. Als wässrige Systeme sind sie nicht umweltbelastend, bzw. sie weisen nur eine geringe Umweltbelastung auf, da höchstens 15 Gew.% an organischem Lösungsmittel eingesetzt wird.

Die Herstellung der erfindungsgemässen photopolymerisierbaren Zusammensetzungen erfolgt z.B. durch Mischen der Komponenten a), b) und d), gegebenenfalls c) und e), unter Rühren bei Raumtemperatur, wobei eine homogene Lösung oder vor allem eine Emulsion oder eine Dispersion erhalten wird.

Verwendet werden die erfindungsgemässen photopolymerisierbaren Zusammensetzungen vor allem als Photoresistsysteme, welche wässrig applizierbar sind und insbesondere zur Beschichtung von Leiterplatten dienen. Die erfindungsgemässen Zusammensetzungen können z.B. als Lötstoppmasken oder als Primärresists zur Herstellung und/oder zum Schutz von Leiterplatten dienen. Die Beschichtung auf das Substrat, vor allem auf eine gereinigte Leiterplatte, kann dabei mit jedem bekannten Verfahren unter Gelblicht aufgetragen werden. Anschliessend wird der Beschichtungsphotolack etwa 1 bis 10 Minuten an der Luft und dann bei etwa 5 bis 20 Minuten bei 70°-100°C getrocknet. Die Beschichtung kann auch direkt ohne Lufttrocknung im Ofen bei 70°-100°C getrocknet werden.

Dann wird der getrocknete Photolack durch eine Photomaske zweckmässig während etwa 5 bis 100 Sekunden mit einer 5000 W Metallhalogen Quecksilberdampflampe belichtet und dann z.B. mit einer wässrigen oder insbesondere einer wässrig-alkalischen Lösung, zweckmässig mit nur 1 %igen wässrig-alkalischen Lösung, entwickelt. Die nicht belichteten Stellen der Beschichtung werden entfernt, und die belichteten Bildstellen werden dann gegebenenfalls ca. 1 Stunde bei etwa 150°C erhitzt, um die Beschichtung nachzuhärten.

Die Belichtung der erfindungsgemässen Zusammensetzungen erfolgt mit aktinischer Strahlung. Dabei handelt es sich in der Regel um UV- und/oder VIS-Strahlung, bevorzugt der Wellenlänge zwischen ca. 220 und 550 nm, speziell zwischen 220 bis 450 nm. Zur Bestrahlung können alle an sich bekannten Strahlungsquellen eingesetzt werden, beispielsweise Quecksilberhochdrucklampen oder UV-/VIS-Laser. Die Verfahrensparameter, wie z.B. Bestrahlungsdauer und Abstand von Strahlungsquelle und strahlungsempfindlicher Schicht, werden im allgemeinen von der Art der strahlungsempfindlichen Zusammensetzung und von den gewünschten Eigenschaften des Ueberzugs abhängen und können vom Fachmann mit wenigen Routineversuchen festgelegt werden. Die bildmässige Belichtung kann z.B. durch eine Photomaske erfolgen oder durch direktes Schreiben eines Laserstrahls auf der strahlungsempfindlichen Schicht.

Nach der Belichtung erfolgt die Entwicklung. Durch die Einwirkung einer Entwicklerlösung können die unbelichteten Stellen des Photoresists entfernt werden. Als Entwickler für erfindungsgemäss verarbeitete Schichten sind vor allem wässerige Lösungen gut geeignet, die bei erfindungsgemässer Verwendung von (Meth)acrylaten alkalisch sein müssen, wenn sich während der Trocknung bereits wieder viele freie Carboxylgruppen in der Beschichtung gebildet haben. Allerdings können auch Entwickler auf Basis organischer Lösungsmittel verwendet werden, z.B. Butyldiglycol, Ethyldiglycol oder γ-Butyrolacton. Da die Entwicklung im allgemeinen in einem geschlossenen Tank erfolgt, besteht hierbei nur eine geringe Gefahr von Lösungsmittelemissionen.

Die Erfindung betrifft daher auch ein Verfahren zur Erzeugung eines Photoresistbildes, das im einzelnen die folgenden Verfahrensschritte enthält:

Aufbringen der erfindungsgemässen, photopolymerisierbaren Zusammensetzung auf ein Substrat, Entfernung des Wassers und gegebenenfalls des Lösungsmittels aus der aufgetragenen Zusammensetzung unter Bildung eines Films der photopolymerisierbaren Zusammensetzung auf dem Substrat, Belichtung des beschichteten Substrats mit aktinischer Strahlung gemäss einem gewünschten Muster, Entfernung der nicht belichteten Stellen der Beschichtung mit Hilfe einer wässerigen oder alkalisch-wässerigen Lösung unter Freilegung des Substrats und gegebenenfalls eine thermische Härtung und gegebenenfalls UV-Härtung der auf dem Substrat verbliebenen Beschichtung.

Die Herstellung der beschichteten Substrate kann mittels an sich bekannter Beschichtungsverfahren erfolgen, mit denen eine Beschichtung gleichförmig aufgebracht werden kann. Beispiele für solche Beschichtungsverfahren sind Aufschleudern, Siebdruck, Aufpinseln, Aufsprühen, z.B. elektrostatisches Aufsprühen, Reverse-Rollbeschichtung, Tauch- und Rakelbeschichtung und das Vorhanggiessverfahren.

Die Auftragsmenge (Schichtdicke) und die Art des Substrates (Schichtträger) sind vom gewünschten Applikationsgebiet abhängig. Die erfindungsgemässen Zusammensetzungen können in relativ dünnen Schichten, bevorzugt 5 bis 150 µm, aufgebracht werden und bieten eine gute Auflösung. Sie eignen sich bei entsprechend gewählter Strahlenquelle und strahlungsempfindlichen Komponenten für alle üblichen Anwendungsgebiete, wo die Erzeugung von strukturierten Bildern erwünscht ist.

Die erfindungsgemässen Beschichtungen zeigen auch eine ausgezeichnete thermische Widerstandsfähigkeit, wenn sie mit heissen flüssigen Metallen und/oder Legierungen in Kontakt gebracht werden, wie beispielsweise mit einem Lötbad, das gewöhnlich eine Temperatur im Bereich von etwa 270°C aufweist.

Nach der Belichtung und Entwicklung wird die Beschichtung gegebenenfalls noch einer thermischen Nachbehandlung oder Härtung unterworfen. Dazu wird auf eine Temperatur erhitzt, bei der eine Vernetzung stattfinden kann. Die dazu benötigte Temperatur liegt gewöhnlich oberhalb von 100°C, z.B. im Bereich von 120° bis 180° C, vorzugsweise von 120° bis 150° C, während z.B. etwa 1 Stunde. In manchen Fällen kann es auch günstig sein, noch eine zusätzliche Härtung mit UV-Strahlung durchzuführen, die zu einer noch vollständigeren Polymerisation der (Meth)acrylatmonomeren bzw. -oligomeren führen kann. Dies kann beispielsweise gleichzeitig mit einer thermischen Härtung geschehen.

Ueberraschenderweise hat sich weiterhin gezeigt, dass Beschichtungen aus den erfindungsgemässen Zusammensetzungen auf manchen Substraten, z.B. auf üblichen Leiterplattenlaminaten, dann eine besonders gute Qualität zeigen, wenn das Substrat zuvor mit Wasser leicht befeuchtet wird, wie dies z.B. mit Hilfe eines Schwammes oder technisch mit Hilfe einer Gummiwalze möglich ist. Auf diese Weise können z.B. ein besonders gleichmässiger Verlauf und eine äusserst geringe Tendenz zur Blasenbildung beim Trocknen erreicht werden. Bei einer besonders günstigen Ausführungsform des beschriebenen Verfahrens zur Erzeugung einer Beschichtung wird daher das Substrat vor dem Auftragen der Bechichtung befeuchtet.

Die folgenden Beispiele veranschaulichen die Erfindung, ohne sie darauf zu limitieren.

### Beispiel 1:

Durch Mischen der folgenden Komponenten A und B bei Raumtemperatur wird eine photopolymerisierbare Zusammensetzung hergestellt.

Komponente A ist eine organische Phase (Oelphase) und enthält als Komponenten:
31 Gew.% des Reaktionsproduktes aus Epoxykresolnovolak ECN 1299 und Acrylsäure, welches mit Bernsteinsäureanhydrid verestert wurde;
(Säurezahl: 0,7 Eq/kg, 70 % in MPA (Methoxypropylacetat); Acrylatkomponente,
2,2 Gew.% Irgacure 907®), 0,4 Gew.% Quantacure ITX® als Photoinitiator, sowie
7,2 Gew.% mikronisiertes Talkum und 0,2 Gew.% Mikrolith Blau 4G als Zusätze.

Komponente B ist eine wässrige Phase und enthält als Komponenten:
1,8 Gew.% 25%iges wässriges Ammoniak,
2,0 Gew.% N-Methylolacrylamide als Härter, 0,1 Gew.% Benzotriazol als Lackadditiv, 0,1 Gew.% Byk 80 als Entschäumer und
55 Gew.% Wasser.

Die Komponenten A und B werden unter Rührung zusammengemischt, wobei eine homogene, stabile Photoresist-Emulsion entsteht. Unter Gelblicht wird der wässrige Photolack auf eine gereinigte Leiterplatte mit einem Ziehrakel (etwa 125 µm Nassfilmdicke) aufgebracht. Man trocknet 10 Minuten an der Luft und weitere 20 Minuten bei 80°C. Danach wird durch eine Photomaske 20 Sekunden mit einer 5000 W Metallhalogen-Quecksilberdampflampe belichtet. Anschliessend wird mit 1%iger wässriger Natriumcarbonatlösung bei etwa 30°C entwickelt, wobei sich die nicht belichteten Stellen der Beschichtung lösen. Die so entwickelte Leiterplatte wird eine Stunde auf eine Temperatur von 150°C erhitzt, um die restliche Beschichtung nachzuhärten.

Die so beschichtete Platte wird für 10 Sekunden in ein 270°C heisses Lötbad getaucht. Sie weist keine sichtbare Veränderung nach dem Löten auf.

### Beispiel 2:

Die folgenden Komponenten A und B werden, soweit nichts anderes vermerkt ist, wie in Beispiel 1 verarbeitet:

Komponente A:
31 Gew.% des Reaktionsproduktes aus Epoxykresolnovolakharzes ECN 1299 und Acrylsäure, welches mit Tetrahydrophthalsäure verestert wurde:
(Säurezahl: 1 Eq/kg; 71 %ig in MPA),
2,2 Gew.% Irgacure 907® und 0,4 Gew.% Quantacure ITX® als Photoinitiator, sowie
7,2 Gew.% mikronisiertes Talkum und 3,5 Gew.% des Epoxyphenolnovolakharzes EPN 1139 als Komponente C und 0,2 Gew.% Mikrolith Blau 4G.

Komponente B:
2,4 Gew.% 25%iges, wässriges Ammoniak,
0,1 Gew.% Benzotriazol als Lackadditiv, 0,1 Gew.% Byk 80 als Entschäumer, und
52,9 Gew.% Wasser.

Mit dieser Zusammensetzung werden Prüfplatten gemäss Norm IPC B-25 beschichtet. Nach der Aushärtung werden die Platten einem elektrolytischen Korrosionstest unter den folgenden Bedingungen unterworfen: 42°C, 90 % relative Luftfeuchtigkei; 100 V Spannung, 21 Tage Dauerbelastung.

Die so belastete Platte zeigt keine sichtbare Veränderung oder Verfärbung.

### Beispiel 3:

Es wird die gleiche Zusammensetzung wie in Beispiel 1 hergestellt, mit der Ausnahme, dass anstelle des Epoxidharzes gleiche Mengen des avancierten Epoxykresolnovolakharzes ECN 1299 [avanciert mit Bisphenol A mit einem Epoxywert von 4,1 Äquivalent/kg und dann mit Acrylsäure umgesetzt und anschliessend mit Bernsteinsäureanhydrid verestert; Säurezahl 0,9 Val/kg, hergestellt gemäss Beispiel 3 der am 2. Juli 1993 hinterlegten Schweizerischen Patentanmeldung Anmeldenummer 2004/93-2; Titel: Epoxyacrylate; aufkonzentriert auf 69 % Festkörper] verwendet werden.

Nach dem Löttest (10 Sek. bei 270°C) wird keine sichtbare Veränderung festgestellt.

### Beispiel 4:

Es wird die gleiche Zusammensetzung wie in Beispiel 1 hergestellt, mit der Ausnahme, dass anstelle des Epoxidharzes gleiche Mengen eines nachglycidylisierten Bisphenol A Epoxidharzes [Epoxywert 2,8 Äquivalent/kg; mit Acrylsäure umgesetzt und dann mit Bernsteinsäureanhydrid verestert; Säurezahl 0,9 Eq/kg, 70 % in Methoxypropylacetat; hergestellt gemäss Beispiel 15 der am 2. Juli 1993 hinterlegten Schweizerischen Patentanmeldung Anmeldenummer 2003/93-0; Titel: Epoxyacrylate] verwendet werden.

Die gehärtete Platte wird einem Gitterschnitt nach DIN 46033 unterworfen. Sowohl auf dem Laminat als auch auf dem kupferkaschierten Laminat beträgt der Wert Null.

## Patentansprüche

1. Photopolymerisierbare Zusammensetzung, die ohne Zusatz von hochmolekularen Binderpolymeren auskommen, enthaltend
a) 20 bis 80 Gew.% eines spezifischen filmbildenden Säuregruppen enthaltenden Acrylates mit höherem Molekulargewicht, welches mit Ammoniak oder einem Amin oder einer anorganischen Base neutralisiert ist, wobei mindestens 10 Gew.% der Komponente a) aus einem höhermolekularem Acrylat al) bestehen, welches sich aus einem Reaktionsprodukt eines höhermolekularen, mit einem Bisphenol avancierten Epoxidharzes und einer ethylenisch ungesättigten Monocarbonsäure und nach anschliessender Umsetzung mit einem cyclischen Anhydrid einer Polycarbonsäure herleitet,
b) 0,1 bis 15 Gew.% einer Photoinitiatorverbindung,
c) gegebenenfalls 1 bis 25 Gew.% Zusätze, und
d) Wasser oder neben Wasser noch bis zu 15 Gew.% eines organischen Lösungsmittels enthält, und Wasser die Balance zu 100 Gew.% bildet, sowie
e) gegebenenfalls noch mindestens ein (Meth)Acrylat-Monomer oder (Meth)Acrylat-Oligomer oder eine durch Licht vernetzbare Vinylverbindung enthält.

2. Photopolymerisierbare Zusammensetzung gemäss Anspruch 1, dadurch gekennzeichnet, dass sie als Komponente a) ein mit einem cyclischen Anhydrid einer Polycarbonsäure umgesetztes acryliertes Derivat von mit Bisphenolen avancierten Epoxyharzen enthält.

3. Photopolymerisierbare Zusammensetzung gemäss Anspruch 1 , dadurch gekennzeichnet, dass sie als Komponente c) einen thermischen Härter und/oder ein Pigment oder einen wasserunlöslichen Farbstoff und/oder einen Füllstoff und/oder Zusätze für wässrige Lacke (Lackadditive) enthält.

4. Photopolymerisierbare Zusammensetzung gemäss Anspruch 1, dadurch gekennzeichnet, dass sie als Komponente b) Irgacure 907® und/oder Quantacure ITX® enthält.

5. Verfahren zur Herstellung einer Zusammensetzung nach Anspruch 1, dadurch gekennzeichnet, dass die Komponenten a), b) und d), gegebenenfalls c) und e) bei Raumtemperatur unter Rühren zu einer homogenen Emulsion oder Dispersion zusammengemischt werden.

6. Verwendung von photopolymerisierbaren Zusammensetzungen gemäss Anspruch 1 zur Bildung einer photopolymerisierbaren Schicht auf einem Substrat.

7. Verwendung gemäss Anspruch 6 zur Beschichtung von Leiterplatten.

8. Verwendung gemäss Anspruch 6 als Lötstoppresist für Leiterplatten oder als Ätzresists oder Galvanoresist zur Herstellung von Leiterplatten.

## Claims

1. A photopolymerisable composition comprising, without the addition of binder polymers of high molecular weight,
a) 20 to 80 % by weight of a specific film-forming, acid group-containing acrylate of relatively high molecular weight which is neutralised with ammonia or an amine or an inorganic base, at least 10 % by weight of component a) consisting of an acrylate of relatively high molecular weight al) which is derived from a reaction product of an epoxy resin of relatively high molecular weight, which is advanced with a bisphenol, and an ethylenically unsaturated monocarboxylic acid and after subsequent reaction with a cyclic anhydride of a polycarboxylic acid,
b) 0.1 to 15 % by weight of a photoinitiator compound,
c) optionally 1 to 25 % by weight of additives, and
d) water, or water and up to 15 % by weight of an organic solvent, with water forming the balance to 100 % by weight, and also comprises
e) optionally at least one additional (meth)acrylate monomer or (meth)acrylate oligomer or a vinyl compound that can be crosslinked by light.

2. A photopolymerisable composition according to claim 1, wherein component a) is an acrylicized derivative of epoxy resins advanced with bisphenols which is reacted with a cyclic anhydride of a polycarboxylic acid.

3. A photopolymerisable composition according to claim 1, wherein component c) is a thermal hardener and/or a pigment or a water-insoluble dye and/or a filler and/or additives for aqueous coating materials (coatings additives).

4. A photopolymerisable composition according to claim 1, wherein component b) is Irgacure 907® and/or Quantacure ITX®.

5. A process for preparing a composition according to claim 1, wherein components a), b) and d), and optionally c) and e), are mixed together with stirring at room temperature to give a homogeneous emulsion or dispersion.

6. Use of a photopolymerisable composition according to claim 1 to form a photopolymerisable layer on a substrate.

7. Use according to claim 6 for coating printed circuit boards.

8. Use according to claim 6 as solder resist for printed circuit boards or as etch resists or galvanoresist for the fabrication of printed circuit boards.

## Revendications

1. Composition photopolymérisable que l'on peut utiliser sans addition de liants polymères de haut poids moléculaire, contenant
a) de 20 à 80 % en poids d'un acrylate spécifique filmogène de poids moléculaire élevé contenant des groupes acides, que l'on neutralise par l'ammoniac ou par une amine ou une base inorganique, au moins 10 % en poids du composant a) étant constitués d'un acrylate de haut poids moléculaire al), qui dérive d'un produit de réaction d'une résine époxyde de haut poids moléculaire avance par un bisphénol et d'un acide monocarboxylique à insaturation éthylénique et après réaction consécutive avec un anhydride cyclique d'un acide polycarboxylique organique,
b) de 0,1 à 15 % en poids d'un composé photoamorceur,
c) éventuellement de 1 à 25 % en poids d'additif, et
d) l'eau ou, au côté de l'eau, contenant encore jusqu'à 15 % en poids d'un solvant organique, et l'eau qui forme le complément à 100 % en poids, ainsi que
e) éventuellement encore au moins un monomère (méth)acrylate ou oligomère (méth)acrylate ou un composé vinylique photoréticulable.

2. Composition photopolymérisable selon la revendication 1, caractérisée en ce qu'elle contient en tant que composant a) un dérivé acrylé d'une résine époxyde avancée par des bisphénols que l'on a fait réagir avec un anhydride cyclique d'un acide polycarboxylique.

3. Composition photopolymérisable selon la revendication 1, caractérisée en ce qu'elle contient en tant que composant c) un durcisseur thermique et/ou un pigment ou un colorant insoluble dans l'eau et/ou une charge et/ou des additifs pour des vernis aqueux (additifs de vernis).

4. Composition photopolymérisable selon la revendication 1, caractérisée en ce qu'elle contient en tant que composant b) Irgacure 907® et/ou Quantacure ITX®.

5. Procédé pour la préparation d'une composition selon la revendication 1, caractérisé en ce qu'on mélange les composants a), b) et d), éventuellement c) et e), à la température ambiante, en agitant, pour obtenir une émulsion ou dispersion homogène.

6. Utilisation de compositions photopolymérisables selon la revendication 1 pour former une couche photopolymérisable sur un substrat.

7. Utilisation selon la revendication 6 pour le revêtement de plaquettes de circuits imprimés.

8. Utilisation selon la revendication 6 comme résist d'arrêt de brasage pour les circuits imprimés ou comme résist de décapage ou comme galvanorésist pour la préparation de plaquettes de circuits imprimés.
